Europäisches Patentamt

European Patent Office

Office européen des brevets

(19)

(11) Publication number: **0 138 162**
**A2**

(12) # EUROPEAN PATENT APPLICATION

(21) Application number: **84111871.4**

(22) Date of filing: **04.10.84**

(51) Int. Cl.⁴: **H 01 L 27/08, H 01 L 21/74**

(30) Priority: **14.10.83 US 541922**

(43) Date of publication of application: **24.04.85 Bulletin 85/17**

(84) Designated Contracting States: **DE FR GB**

(71) Applicant: **International Business Machines Corporation, Old Orchard Road, Armonk, N.Y. 10504 (US)**

(72) Inventor: **Fang, Frank Fu, 1691 Cardinal Court, Yorktown Heights New York 10598 (US)**
Inventor: **Hu, Genda James, 304 Alicia Way, Los Altos California 94022 (US)**

(74) Representative: **Hobbs, Francis John, IBM United Kingdom Patent Operations Hursley Park, Winchester, Hants, SO21 2JN (GB)**

(54) **CMOS structure.**

(57) In order to enhance resistance to positive feedback latch-up, a CMOS structure includes a degeneratively doped ($n^+$) grid (28) buried in the (p) epitaxial layer (12) to intercept electrons injected into the epitaxial layer (12) before they can flow into an FET-containing ($n^-$) well (30).

The ($n^-$) well (30) is formed in the (p) epitaxial layer (12) which is supported on a degeneratively doped ($p^+$) substrate (10). A first FET including a grounded ($n^+$) source (22) and an ($n^+$) drain (24) with an associated gate (26) is separated by recessed oxide region (20) from a second FET including a positively biased ($p^+$) source 14 and a ($p^+$) drain (16) formed in the ($n^-$) well (30).

The $p^+$ substrate is biased to behave like a very efficient hole collector, allowing a minimum number of holes to flow to the ($p^-$) epi region to cause positive feedback for the $n^+p$ junction.

However, the $p^+$ substrate cannot handle the electrons injected from the $n^+$ source and positive feedback can be created between the $p^+n$ junction between the $n^+$ source and the $p^-$ substrate. The buried degeneratively doped ($n^+$) grid intercepts the electrons injected into the epitaxial region before they can flow into the $n^-$ well and create a positive feedback condition.

## CMOS STRUCTURE

This invention relates to CMOS structures.

CMOS integrated semiconductor circuits commonly contain parasitic PNPN structures which can give rise to an undesired SCR action commonly known as "latch-up", wherein the device, under certain conditions, is turned on by forward biasing of one of the junctions in the PNPN structure. The device remains "on" even after the signal which produced the forward biasing is removed, and this will prevent the operation of the logic junction of the circuits and if the situation persists, it may eventually lead to destruction of the device or metal by excessive current flow.

Heretofore, there have been attempts to eliminate latch-up in such devices by techniques such as turning on power supplies in special sequences, using external components, or avoiding transients.

However, as the device dimensions become smaller and integration becomes greater there are many applications wherein these techniques cannot be employed successfully.

There have also been attempts to eliminate latch-up through fabrication techniques such as the insulator separation method involving the use of dielectric insulation to eliminate parasitic bipolar transistors in a CMOS device. Other such techniques have included the use of a sapphire substrate and the reduction of current gain by decreasing minority carrier lifetime in the base by techniques such as gold doping, exposing the CMOS structure to X-ray and gamma ray radiation, by making the "base" of the parasitic bipolar transistors very deep resulting in a low current gain and a high minority base transit time. Other techniques include the forming of an impurity diffusion region in a semiconductor surface area in order to shut off a current passage between the parasitic pnp transistor and the npn transistor, reducing the DC current amplification factor of pnp and npn transistors by elongating

Y09-83-043 2 0138162

their effective base lengths, and inserting a resistor between a power source and the source of the CMOS transistor. These techniques are subject to a number of problems, including excessive junction leakage, sacrifice of circuit density, failure to completely eliminate latch-up, low device yield, limited throughput, and high manufacturing cost.

More particularly, U. S. Patents 4,161,417 and 4,203,126 to Yim et al describe a method and structure for making a CMOS device wherein a buried region is provided to effect minimum latch-up. More particularly, in a first conductivity type substrate having an upper layer of first conductivity type epi, a buried region of second conductivity type proximate to a second conductivity type well is provided in the substrate and epi layer intermediate the P source and drain and N source and drain of the FET devices. In the specific embodiment shown in the patents, the first conductivity is N and the second conductivity is P; however, the claim describes devices wherein N conductivity buried regions and wells can be located in P conductivity substrates and epi layers.

In Japanese patent 153367 issued November 29, 1980 to Ogawa and entitled SEMICONDUCTOR DEVICE, a $N^+$ type region is formed on the main surface of $N^+$ type semiconductor substrate, and a P-type region is formed on the surface region of a section on the above $N^+$ region. When performing a diffused formation of the $P^+$ type region, the impurities of the substrate are diffused within the $N^+$ region contacting to the substrate, and an $N^+$ type region is formed. Hence, as a C-MOS is formed on the substrate, the series resistance value in the substrate and the region is low, so that the voltage drop is not sufficient to give a parasitic PNP transistor sufficient gain to cause latch-up due to the above-mentioned resistance.

In U.S. Patent 4,327,368 a complementary type MOS transistor device is disclosed including a p-channel type MOS transistor having source, drain and gate regions formed in the n-well region which is formed in the surface area of a p-type semiconductor layer and an n-channel MOS Transistor having source, drain and gate regions formed in said semiconductor layer. The semiconductor layer is formed on an n-type semiconductor body and a reverse bias voltage is applied between the semiconductor layer and the semiconductor substrate to prevent latch-up.

According to the invention, there is provided a CMOS structure including pairs of complementary FET devices formed respectively in an epitaxial layer (30) of one (p) conductivity type and in wells (30) of the opposite conductivity type (n), the epitaxial layer being supported by a degeneratively doped substrate (10) of said one conductivity type ($p^+$), the structure being characterised by a degeneratively doped grid (28) of said other conductivity type ($n^+$) being buried in the epitaxial region.

The structure of the present invention is distinct over the prior art in that a grid of buried minority carrier collectors is used in the CMOS structure to collect one type of minority carriers whereas the substrate is used to collect the minority of the opposite polarity to resist latch-up conditions. In latch-up occurrences, positive holes from the $p^+$ source and negative electrons from the $n^+$ source of the p-channel and n-channel FETs, respectively, are injected into the n-well body and $p^+$ substrate, respectively. The ground or negative potential substrate collects the positive holes so they are not fed back to the $n^+$ source. In the present invention, a buried grid of $n^+$ collectors is included to similarly collect the negative electrons injected from the $n^+$ source so they are not fed back to the $p^+$ source to cause latch-up.

Although the Yim et al references include a buried region, the present invention differs from Yim et al in that the buried grids are interconnected and may be biased and they are not required to be aligned to the well. Also the heavily doped bottom of epi layer of opposite conductivity type is used in conjunction with the grid and are reverse biased with respect to the respective surrounding. Thus, they act as effective collectors for the respective n-p-n or p-n-p parasitic bipolar transistors, which is fundamentally different in operating principle as Yim et al in which the buried boundary region is used as a minority carrier diffusion barrier and not as a collector. Furthermore, the collector action serves to clean out all minority carriers, i.e., electrons and holes, before any latch-up conditions can be formed and sustained latch-up boundary condition is not allowed.

How the invention can be carried out will now be described by way of example with reference to accompanying drawing which represents a cross-section of a CMOS structure including a buried $n^+$ collector for enhancing the resistance to latch-up.

A $p^+$ substrate 10 is provided with an upper $p^-$ epitaxial region 12. A second device including a biased (+Vdd) $p^+$ source 14 and $p^+$ drain 16 with an associated gate 18 is separated by recessed oxide region 20 from a first device including grounded $n^+$ source 22 and $n^+$ drain 24 with an associated gate 26.

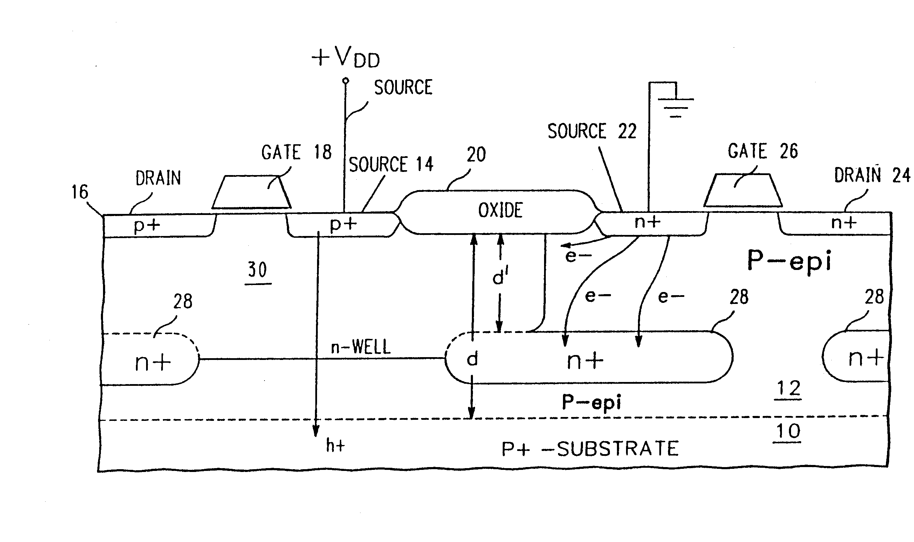

It is known that in operation of a conventional CMOS structure, both the junctions $p^+$ source 14 to $n^-$ well 30 and $n^+$ source 22 to p epi region 12 are forward biased. Holes ($h^+$) are injected from the $p^+$ region and electrons ($e^-$) are injected from the $n^+$ source region. These holes and electrons are depicted in the drawing as being injected from $p^+$ source 14 and $n^+$ source 22, respectively.

The $p^+$ substrate 10, which is biased at ground or a negative potential, normally behaves like a very efficient hole collector, allowing fewer holes to flow to the $p^-$ epi region to cause positive feedback for the $n^+p$ junction 22-12. Thus, it is recognised in the prior art that a $p^+$ substrate can increase the resistance against latch-up.

However, the $p^+$ substrate 10 cannot handle the electrons injected from the $n^+$ source 22, and positive feedback can be created between $p^+n$ junction between 14 and $n^-$ well 30.

In the present invention, buried $n^+$ collector regions are introduced into the substrate. These $n^+$ regions 28 are illustrated in the
drawing as disposed in the $p^-$ epi region 12. The $n^+$ collector regions
function to intercept the electrons injected into the p-type epitaxial
region before the electrons can flow into the $n^-$ well 30 and create a
positive feedback condition.

It is seen from the drawing that the injected minority carriers,
that is electrons from source 22 and holes from source 14, have the
shortest path towards their respective collectors 28 and 10. Since the
electron collectors 28 are disposed in a grid, there is little possibility for electrons to drift to the $n^-$ well 30 region to cause a
latch-up condition.

The $n^+$ grid 28 in the $p^-$ epi layer may be formed by deep ion
implantation of either As or Phosphorus through a mask. Alternatively,
it can be deposited at an intermediate step. More particularly, the $n^+$
grid pattern can be formed at an intermediate depth of the $p^-$ epi growth
by either shallow implantation or shallow diffusion through a suitable
mask and then growth of the $p^-$ epi is continued to the desired thickness
for FET devices. The pattern of the $n^+$ grid does not need to be
registered to any device or circuit configuration. Therefore, the
configuration of this structure is a batch substrate preparation which
does not include critical alignment steps.

What has been described is a complementary semiconductor device
including buried collector regions for minimising latch-up conditions.
Specifically, buried $n^+$ collector regions have been described for
collecting minority carrier electrons.

CLAIMS

1.    A CMOS structure including pairs of complementary FET devices
formed respectively in an epitaxial layer (30) of one (p) conductivity
type and in wells (30) of the opposite conductivity type (n), the
epitaxial layer being supported by a degeneratively doped substrate (10)
of said one conductivity type ($p^+$), the structure being characterised by
a degeneratively doped grid (28) of said other conductivity type ($n^+$)
being buried in the epitaxial region.

2.    A CMOS structure comprising a substrate composed of degeneratively
doped first conductivity type semiconductor material having an upper
region of epitaxial material and a second conductivity well region in
said epitaxial region,

a first field effect transistor (FET) device disposed on said
substrate including a first source electrode, a first drain electrode
and a first gate electrode, said first source and drain electrodes being
composed of second conductivity type material,

a second field effect transistor (FET) device disposed on said
second conductivity well region including a second source electrode, a
second drain electrode and a second gate electrode, said second source
and drain electrodes being composed of first conductivity type material,

means for applying a first bias voltage to said first source
electrode such that under one level of gate condition said first gate
inverts the surface of said first FET under said first gate into second
conductivity type thus causing said first FET to conduct, and under
another level of gate condition to cause said first FET to be non-
conducting,

means for applying a second bias voltage to said second source
electrode such that under one level of gate condition said second FET is caused to be non-conducting and under another level of gate condition said second FET is caused to be non-conducting,

and a degeneratively doped grip of collector regions of second conductivity type material buried in said region of epitaxial material for preventing second type carriers from said first source from entering into said substrate region of said first conductivity type and causing latch-up.

3.    A CMOS structure as claimed in Claim 2, wherein said first transistor device includes source and drain electrodes composed of $N^+$ conductivity semiconductor material, said second transistor device is complementary to said first transistor device and includes $P^+$ conductivity source and drain electrodes.

4.    A CMOS structure as claimed in Claim 3, wherein in said normal operation said first $N^+$ source electrode injects $e^-$ electrons into said epitaxial region and said second $P^+$ source electrode injects $h^+$ holes into said epitaxial region.

5.    A CMOS structure as claimed in Claim 4, wherein said collector regions buried in said epitaxial region are composed of $n^+$ type material in the form of buried grids for preventing said $e^-$ electrons injected from said first source electrode from entering into said p-type substrate region.

6.    A CMOS structure as claimed in Claim 4 or Claim 5, wherein said degeneratively doped first conductivity type substrate is P-type and functions to collect all the $h^+$ holes injected from said $P^+$ second source electrode of said second FET device.

+V$_{DD}$

SOURCE

GATE 18

SOURCE 14

20

SOURCE 22

GATE 26

DRAIN 24

DRAIN

16

p+

p+

OXIDE

n+

n+

P-epi

30

e-

d'

28

n+

n-WELL

d

n+

e-

e-

28

n+

28

12

P-epi

h+

P+ -SUBSTRATE

10